# EUROPÄISCHE PATENTSCHRIFT

(11) **EP 2 685 507 B1**
(45) Veröffentlichungstag und Bekanntmachung des Hinweises auf die Patenterteilung: **13.11.2019**
(21) Anmeldenummer: 12175486.5
(22) Anmeldetag: 09.07.2012
(51) Int. Cl.: H01L 31/02, H01L 31/048, H02S 40/34, H01L 31/046

(54) **Solarmodul mit Anschlussanordnungen für elektrischen Außenanschluss**
Solar module with connection assemblies for electrical external connection
Module solaire doté d'agencements de raccordement pour raccord électrique extérieur

(43) Veröffentlichungstag der Anmeldung: 15.01.2014
(73) Patentinhaber: (CNBM) Bengbu Design & Research Institute for Glass Industry Co., Ltd., Bengbu (CN)
(72) Erfinder: Kuster, Hans-Werner, 52066 Aachen (DE); Rateiczak, Mitja, 52164 Würselen (DE)
(74) Vertreter: Gebauer, Dieter Edmund

(56) Entgegenhaltungen:
- WO-A1-2008/150558
- WO-A2-2008/148524
- US-A1- 2005 000 562

## Beschreibung

Photovoltaische Schichtensysteme zur Umwandlung von Sonnenlicht in elektrische Energie sind hinlänglich bekannt. Gemeinhin werden diese als "Solarzellen" bezeichnet, wobei sich der Begriff "Dünnschichtsolarzellen" auf Schichtensysteme mit Dicken von nur wenigen Mikrometern bezieht, die ein Trägersubstrat für eine ausreichende mechanische Festigkeit benötigen. Da mit einzelnen Solarzellen in der Regel nur Spannungspegel von weniger als 1 Volt erreicht werden, ist es üblich, eine Vielzahl Solarzellen in einem Solarmodul seriell zu verschalten. Hierbei bieten Dünnschichtsolarmodule den besonderen Vorteil, dass die Solarzellen schon während der Schichtenherstellung in integrierter Form verschaltet werden können. Dünnschichtsolarmodule sind in der Regel in Verbundscheibenstruktur ausgebildet, bei der sich die Solarzellen zwischen zwei fest miteinander verbundenen Einzelscheiben befinden. In der Patentliteratur wurden Dünnschichtsolarmodule bereits vielfach beschrieben. Lediglich beispielhaft sei in diesem Zusammenhang auf die Druckschriften DE 4324318 C1 und EP 2200097 A1 verwiesen. Generell verfügen seriell verschaltete Solarzellen über zwei Sammelelektroden gegensätzlicher Polarität zum Abgreifen der erzeugten Gesamtspannung. Typischer Weise sind auf die Sammelelektroden streifenförmige Sammelleiter (Busbars) aufgebracht, wodurch ein einfacherer elektrischer Außenanschluss beispielsweise im Randbereich des Solarmoduls ermöglicht ist. Siehe auch das Dokument WO 2008/150558 A1.

In der industriellen Serienfertigung von Solarmodulen ist es üblich, die Sammelleiter an Folien- bzw. Flachbandleiter anzuschließen, die durch Bohrlöcher der hinteren Modulscheibe auf die Modulrückseite geführt werden. Auf der Modulrückseite werden die Folienleiter an Anschlussgehäuse angeschlossen, die eine Basis für elektrische Anschlussbauteile wie Anschlussleiter oder Anschlussstecker darstellen und einen elektrischen Außenanschluss ermöglichen. Ein solches Anschlussgehäuse ist beispielsweise aus der deutschen Patentanmeldung Nr. 102005025632 A1 bekannt.

Eine automatisierte Fertigung solcher Solarmodule ist in der Praxis nur schwierig zu bewerkstelligen, da die dünnen Folienleiter für die Handhabung durch Roboter nicht geeignet sind. Bei einer aus der Praxis bekannten alternativen Vorgehensweise wird ein Sammelleiter deshalb nicht von einem Folienleiter sondern von einer Kontaktfeder kontaktiert, die ein Bohrloch der hinteren Modulscheibe durchsetzt und dabei zur Anlage gegen den Sammelleiter gelangt. Dies hat den Vorteil, dass die Kontaktfeder bereits mit dem Aufsetzen des Anschlussgehäuses auf die Modulrückseite in Kontakt mit dem Sammelleiter gebracht werden kann, was wesentlich einfacher automatisierbar ist.

Jedoch müssen bei den geschilderten Vorgehensweisen stets Bohrlöcher in die hintere Modulscheibe einbracht werden, wodurch in nachteiliger Weise eine lokale Schwächung der Modulscheibe erzeugt wird. Zudem erfordert das Ausbilden der Bohrlöcher einen zusätzlichen Verfahrensschritt, der mit Zeit und Kosten verbunden ist und zwangsläufig die Ausschussquote bei der Herstellung von Solarmodulen erhöht.

Die internationale Patentanmeldung WO 2012/055808 A2 offenbart eine alternative Vorgehensweise, bei der die Sammelelektrode bzw. Sammelleiter mit einem Folienleiter elektrisch verbunden wird, der zwischen den beiden Substraten aus dem Verbund herausgeführt wird.

Demgegenüber besteht die Aufgabe der vorliegenden Erfindung darin, herkömmliche Solarmodule so weiterzubilden, dass eine automatisierte Herstellung noch einfacher und kostengünstiger durchführbar ist. Diese und weitere Aufgaben werden nach dem Vorschlag der Erfindung durch ein Solarmodul und ein Verfahren zur Herstellung eines Solarmoduls mit den Merkmalen der nebengeordneten Patentansprüche gelöst. Vorteilhafte Ausgestaltungen der Erfindung sind durch die Merkmale der Unteransprüche angegeben.

Erfindungsgemäß ist ein Solarmodul, insbesondere Dünnschichtsolarmodul, mit einem laminierten Verbund aus zwei flächigen Substraten gezeigt. In dem Verbund sind die beiden Substrate so ausgebildet, dass wenigstens ein Substratrand des einen Substrats relativ zu einem gegenüberliegenden Substrandrand des anderen Substrats nach innen rückversetzt ist, so dass eine Modulrandzone mit einem überstehenden Substratrandbereich (des anderen Substrats) gebildet wird. Hierbei kann es vorgesehen sein, dass die Modulrandzone nur auf einer Modulseite (bzw. Modulrand) des in der Regel rechteck- bzw. quaderförmigen Solarmoduls ausgebildet ist, wobei gleichermaßen denkbar ist, eine solche Modulrandzone jeweils an einander gegenüberliegenden oder aneinander angrenzenden Modulseiten (bzw. Modulränder) vorzusehen, so dass das Solarmodul zwei oder mehr Modulrandzonen aufweist. Die beiden Substrate können beispielsweise anorganisches Glas, Polymere oder Metalllegierungen enthalten und können in Abhängigkeit von Schichtdicke und Materialeigenschaften als starre Platten oder biegsame Folien ausgestaltet sein.

Zwischen den beiden Substraten befinden sich seriell verschaltete Solarzellen. Diese werden durch einen Schichtenaufbau gebildet, der wie üblich über eine Frontelektrodenschicht, eine Rückelektrodenschicht und eine zwischen den beiden Elektrodenschichten befindliche Halbleiterschicht verfügt. Bei dem Solarmodul handelt es sich vorzugsweise um ein Dünnschichtsolarmodul mit in integrierter Form seriell verschalteten Dünnschichtsolarzellen. Beispielsweise besteht die Halbleiterschicht aus einer Chalkopyrit-Verbindung, bei der es sich insbesondere um einen I-III-VI-Halbleiter aus der Gruppe Kupfer-Indium/Gallium-Dischwefel/Diselenid (Cu(In/Ga)(S/SE)₂), beispielsweise Kupfer-Indium-Diselenid (CuInSe₂ bzw. CIS) oder verwandte Verbindungen, handeln kann.

An zwei Sammelelektroden gegensätzlicher Polarität kann die durch die seriell verschalteten Solarzellen erzeugte Gesamtspannung abgegriffen werden. Für einen Außenanschluss umfasst das Solarmodul zwei Anschlussanordnungen, die jeweils einer Sammelelektrode zugeordnet sind. Die Anschlussanordnungen verfügen jeweils über ein mit der zugeordneten Sammelelektrode elektrisch leitend verbundenes Anschlussband und ein am Verbund befestigtes Anschlussgehäuse mit einem mit dem Anschlussband elektrisch leitend verbundenen Anschlussbauteil, beispielsweise eine Anschlussleitung oder ein Anschlussstecker, das für einen elektrischen Außenanschluss dient. Die beiden Anschlussanordnungen können ein gemeinsames Anschlussgehäuse oder jeweils ein separates Anschlussgehäuse aufweisen.

Die Anschlussbänder umfassen jeweils einen Folienleiter, welcher beispielsweise aus einem Metall wie Aluminium oder verzinntem Kupfer besteht, wobei aber auch andere elektrisch leitende Materialien verwendet werden können, die sich zu Folien verarbeiten lassen. Beispiele hierfür sind Aluminium, Gold, Silber oder Zinn und Legierungen hiervon. Der Folienleiter kann beispielsweise eine Dicke im Bereich von 0,03 mm bis 0,3 mm, eine Länge im Bereich von 30 bis 50 mm und eine Breite im Bereich von 5 bis 15 mm haben. Eine Verbindung zwischen Sammelelektrode und Anschlussband erfolgt beispielsweise durch Schweißen, Bonden, Löten, Klemmen, Kleben mittels eines elektrisch leitfähigen Klebers oder Ultraschallverbinden.

Vorteilhaft sind die Anschlussbänder jeweils durch einen elektrischen Sammelleiter mit der zugehörigen Sammelelektrode elektrisch leitend verbunden, was eine einfache und kostengünstige Kontaktierung an einer günstigen Stelle, beispielsweise angrenzend zum Modulrand ermöglicht. Der Sammelleiter ist vorzugsweise band- bzw. streifenförmig ausgebildet und beispielsweise im (Sieb-)Druckverfahren auf den die Sammelelektrode bildenden Elektrodenbereich aufgedruckt. Denkbar ist jedoch auch, den Sammelleiter als Folienleiter auszubilden. Eine Verbindung zwischen Sammelleiter und Anschlussband erfolgt beispielsweise durch Schweißen, Bonden, Löten, Klemmen, Kleben mittels eines elektrisch leitfähigen Klebers oder Ultraschallverbinden.

In einer jeweiligen Anschlussanordnung ist das Anschlussband zwischen den beiden Substraten seitlich aus dem Verbund herausgeführt, wobei das Anschlussband um den nach innen rückversetzten Substratrand herum auf die Substrataußenfläche geführt ist, was eine einfache Fertigung und Kontaktierung durch das Anschlussbauteil im Anschlussgehäuse ermöglicht. Durch den überstehenden Substratrandbereich wird das Anschlussband vor mechanischen Krafteinwirkungen geschützt.

Das Anschlussgehäuse wird beispielsweise aus einem elektrisch isolierenden Werkstoff hergestellt, wobei sich für eine industrielle Fertigung thermoplastische Kunststoffe und Elastomere anbieten, die im Spritzgussverfahren verarbeitet werden können. Als thermoplastische Kunststoffe und Elastomere werden beispielsweise Polyamid, Polyoxymethylen, Polybutylenterephthalat oder Ethylen-Propylen-Dien-Kautschuk verwendet. Alternativ können auch Vergusswerkstoffe wie Acrylat- oder Epoxidharzsysteme verwendet werden. Denkbar ist jedoch auch, das Anschlussgehäuse aus Metall oder einem anderen elektrisch leitenden Werkstoff mit elektrisch isolierenden Einsätzen herzustellen. Das Anschlussgehäuse kann weitere Funktionselemente wie Dioden oder eine Steuerungselektrik aufnehmen.

Eine Befestigung des Anschlussgehäuses am Verbund erfolgt vorteilhaft durch Ankleben, wobei durch die Verklebung das Innere des Anschlussgehäuses gegen Gase, Wasser oder Feuchtigkeit hermetisch abgedichtet werden kann. Insbesondere sind die elektrischen Kontaktstellen vor Korrosion geschützt. Für eine Verklebung kann beispielsweise ein Klebestrang oder ein Klebeband mit einem Kleber auf Acryl-, Polyurethan- oder Polyisobutylenbasis verwendet werden. Zu diesem Zweck wird der Klebstoff auf eine Bodenfläche des Anschlussgehäuses und/oder auf den Verbund aufgebracht und das Anschlussgehäuse auf den Verbund aufgesetzt. Das Anschlussgehäuse ist zumindest abschnittsweise in der Modulrandzone angeordnet, wodurch in einfacher Weise ein Schutz des seitlich aus dem Verbund herausgeführten Anschlussbands vor äußeren Einflüssen erreicht werden kann.

Weiterhin verfügt das Anschlussgehäuse über eine Dichtmassenkammer mit einem Hohlraum, der zur Aufnahme eines um den Substratrand herumgeführten Anschlussbandabschnitts dient. In den Hohlraum ist eine Dichtmasse eingebracht, welche dem um den Substratrand herumgeführten Anschlussbandabschnitt anliegt und nach außen hin abdichtet. Durch diese Maßnahme kann eine einfache und zuverlässige Versiegelung des Anschlussbands erreicht werden.

Zudem weist die Dichtmassenkammer einen den Hohlraum begrenzenden Wandabschnitt auf, der zum überstehenden Substratrandbereich hin spitz zulaufend ausgebildet ist. Der spitz zulaufende Wandabschnitt ermöglicht, dass die Dichtmasse beispielsweise in Form einer Dichtmassenraupe bzw. Dichtmassenstrang auf den überstehenden Substratrandbereich, insbesondere gezielt auf den um den Substratrand herumgeführten Anschlussbandabschnitt, aufgebracht und anschließend das Anschlussgehäuse auf den Verbund aufgesetzt werden kann. Durch den spitz zulaufenden Wandabschnitt kann nicht nur ein Abscheren der Dichtmasse von dem um den Substratrand herumgeführten Anschlussbandabschnitt vermieden werden, vielmehr wird die Dichtmasse auch zum Anschlussbandabschnitt hin gedrückt, so dass eine gas- und wasserdichte Versiegelung des um den Substratrand herumgeführten Anschlussbandabschnitts sichergestellt ist. Es ist somit nicht erforderlich, dass die Dichtmasse vor dem Befestigen des Anschlussgehäuses in die Dichtmassenkammer eingebracht wird. Das Solarmodul ermöglicht somit in besonders vorteilhafter Weise eine automatisierte kostengünstige Herstellung in der industriellen Serienfertigung mit einer zuverlässigen gas- und wasserdichten Versiegelung des Anschlussbands.

Der zum überstehenden Substratrandbereich hin spitz zulaufende Wandabschnitt der Dichtmassenkammer kann in einfacher Weise dadurch ausgebildet sein, dass der Wandabschnitt über eine dem überstehenden Substratrandbereich abschnittsweise anliegende, abgeschrägte Bodenfläche verfügt. Dies ermöglicht auch, dass sich Dichtmasse zwischen dem der abgeschrägten Bodenfläche und dem überstehenden Substratrandbereich befindet, wodurch bei Verwendung einer klebenden Dichtmasse in vorteilhafter Weise eine klebende Befestigung des Anschlussgehäuses am überstehenden Substratrandbereich erreicht werden kann. Das Ankleben des Anschlussgehäuses am Verbund kann somit in einfacher Weise vollautomatisiert durchgeführt werden. Vorzugsweise wird das Anschlussgehäuse auf die Modulrückseite geklebt.

Bei einer weiteren Ausgestaltung des Solarmoduls ist das Anschlussband mit einem Klebemittel, beispielsweise eine doppelseitiges Klebeband, versehen, was eine einfache und kostengünstige Befestigung des Anschlussbands am Substrat, sowie dessen Lagefixierung ermöglicht.

Bei einer weiteren vorteilhaften Ausgestaltung des Solarmoduls verfügt das Anschlussband über einen verzinnten Endabschnitt zur Verbindung mit dem Anschlussbauteil. Dies ermöglicht eine einfache elektrische Verbindung zwischen Anschlussband und Anschlussbauteil.

Bei einer weiteren vorteilhaften Ausgestaltung des Solarmoduls weist das Anschlussgehäuse ein in eine Gehäuseöffnung eingesetztes, herausnehmbares Einsatzteil auf, wobei durch die Gehäuseöffnung ein Zugang zu einer Kontaktkammer zum Verbinden des Anschlussbands mit dem Anschlussbauteil geschaffen wird. Somit kann das Anschlussgehäuse bereits vor dem elektrischen Verbinden von Anschlussband und Anschlussbauteil am Verbund befestigt werden, wodurch der Fertigungsprozess noch weiter vereinfacht ist.

Die Erfindung erstreckt sich weiterhin auf ein Verfahren zur Herstellung eines Solarmoduls, insbesondere Dünnschichtsolarmoduls, welches die folgenden Schritte umfasst:
- Ausbilden einer Serienschaltung aus einer Mehrzahl Solarzellen auf einem ersten Substrat, wobei die Serienschaltung über zwei Sammelelektroden zum Abgreifen der durch die Solarzellen erzeugten Gesamtspannung verfügt;
- Elektrisches Verbinden der Sammelelektroden mit Anschlussbändern;
- Herstellen eines Verbunds aus dem ersten Substrat mit einem zweiten Substrat, wobei wenigstens ein Substratrand des einen Substrats relativ zu einem gegenüberliegenden Substratrand des anderen Substrats nach innen rückversetzt ist, so dass eine Modulrandzone mit einem überstehenden Substratrandbereich gebildet wird, wobei die Anschlussbänder in der Modulrandzone zwischen den beiden Substraten um den nach innen rückversetzten Substratrand herum auf eine Substrataußenfläche geführt werden;
- Aufbringen einer Dichtmasse auf das andere Substrat wenigstens in einem um den Substratrand herumgeführten Anschlussbandabschnitt;
- Aufsetzen eines Anschlussgehäuses mit einem oder mehreren Anschlussbauteilen für einen elektrischen Außenanschluss auf den Verbund, wobei das Anschlussgehäuse eine Dichtmassenkammer zum Aufnehmen der Dichtmasse mit einem spitz zulaufend ausgebildeten Wandabschnitt aufweist, der auf den überstehenden Substratrandbereich aufgesetzt wird;
- Elektrisches Verbinden der mit den Sammelelektroden verbundenen Anschlussbänder mit den Anschlussbauteilen.

### Kurze Beschreibung der Zeichnungen

Die Erfindung wird nun anhand von Ausführungsbeispielen näher erläutert, wobei Bezug auf die beigefügten Figuren genommen wird. Es zeigen:
- Fig. 1: eine schematische Schnittansicht eines Dünnschichtsolarmoduls;
- Fig. 2: eine perspektivische Ansicht des Dünnschichtsolarmoduls von Fig. 1 zur Veranschaulichung einer Anschlussanordnung;
- Fig. 3A-3C: eine perspektivische Ansicht (Fig. 3A) und eine Schnittansicht (Fig. 3B) der Anschlussanordnung von Fig. 2, sowie eine Variante des Anschlussgehäuses (Fig. 3C);
- Fig. 4A-4B: eine perspektivische Ansicht des Anschlussbands im unverbauten Zustand (Fig. 4A) und verbauten Zustand (Fig. 4B).

### Ausführliche Beschreibung der Zeichnungen

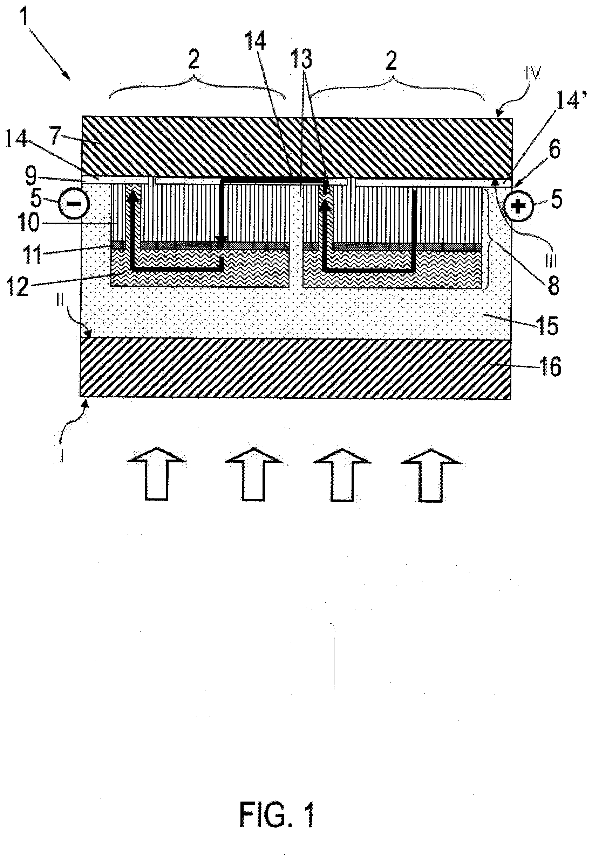

Sei zunächst Figur 1 betrachtet, worin der Aufbau eines insgesamt mit der Bezugszahl 1 bezeichneten Dünnschichtsolarmoduls veranschaulicht ist. Demnach umfasst das Dünnschichtsolarmodul 1 eine Vielzahl in integrierter Form seriell miteinander verschaltete Dünnschichtsolarzellen 2, von denen in Fig. 1 beispielhaft zwei gezeigt sind. Es versteht sich, dass in Dünnschichtsolarmodulen typischer Weise mehr als 100 Dünnschichtsolarzellen 2 seriell miteinander verschaltet sind. Das Dünnschichtsolarmodul 1 ist in Verbundscheibenstruktur ausgebildet und umfasst ein rückseitiges Trägersubstrat 7 und ein vorderseitiges Decksubstrat 16, die jeweils aus einem elektrisch isolierenden Material, beispielsweise Glas oder Kunststoff, bestehen, wobei gleichermaßen andere elektrisch isolierende Materialien mit genügender Festigkeit und inertem Verhalten gegenüber den durchgeführten Prozessschritten eingesetzt werden können. In Abhängigkeit von der jeweiligen Schichtdicke und den spezifischen Materialeigenschaften können die Substrate 7, 16 als starre Platten oder biegsame Folien ausgestaltet sein. Beispielsweise handelt es sich bei dem rückseitigen Trägersubstrat 7 um eine starre Glasplatte mit geringer Lichtdurchlässigkeit und bei dem vorderseitigen Decksubstrat 16 um eine starre Glasplatte aus gehärtetem, extraweißem Glas mit geringem Eisengehalt, welches für Sonnenlicht transparent ist, so dass die Dünnschichtsolarzellen 2 durch auf der Vorderseite (Seite I) des Decksubstrats 16 einfallendes Licht bestrahlt werden können. Allgemein dient das Decksubstrat 16 zur Versiegelung und zum mechanischen Schutz der Dünnschichtsolarzellen 2.

Auf der lichteintrittseitigen Vorderseite (Seite III) des Trägersubstrats 7 ist ein die Dünnschichtsolarzellen 2 bildender Schichtenaufbau 6 aufgebracht, dessen Schichten mittels chemischer Gasphasenabscheidung (CVD), physikalischer Gasphasenabscheidung (PVD) oder Sputtern (magnefeldunterstützte Kathodenzerstäubung) abgeschieden sind. Wie in Fig. 1 erkennbar, umfasst der Schichtenaufbau 6 eine Rückelektrodenschicht 9, beispielsweise aus einem lichtundurchlässigen Metall wie Molybdän, die durch Kathodenzerstäuben auf das Trägersubstrat 7 aufgebracht ist. Die Rückelektrodenschicht 9 hat beispielsweise eine Schichtdicke von etwa 1 µm. Die Rückelektrodenschicht 9 kann gleichermaßen aus einem Schichtstapel mit verschiedenen Einzelschichten bestehen. Des Weiteren umfasst der Schichtenaufbau 6 eine auf die Rückelektrodenschicht 9 aufgebrachte Absorberschicht 8, welche ihrerseits aus mehreren Schichten zusammengesetzt ist. So umfasst die Absorberschicht 8 eine p-dotierte Halbleiterschicht 10, beispielsweise aus einem p-leitenden Chalkopyrithalbleiter. Die Halbleiterschicht 10 hat beispielsweise eine Schichtdicke von 500 nm bis 5 µm, welche insbesondere ca. 2 µm beträgt. Auf die Halbleiterschicht 10 ist eine Pufferschicht 11 abgeschieden, welche beispielsweise aus Cadmiumsulfid (CdS) und intrinsischem Zinkoxid (i-ZnO) besteht. Auf die Pufferschicht 11 ist eine Frontelektrodenschicht 12 beispielsweise durch Aufdampfen aufgebracht. Die Frontelektrodenschicht 12 ist für Strahlung in einem für die Halbleiterschicht 10 empfindlichen Spektralbereich transparent ("Fensterschicht") und basiert beispielsweise auf einem dotierten Metalloxid, insbesondere n-leitendes, Aluminium-dotiertes Zinkoxid. Die Schichtdicke der Frontelektrodenschicht 12 beträgt beispielsweise 300 nm. Durch die Frontelektrodenschicht 12, die Pufferschicht 11 und die Halbleiterschicht 10 wird ein pn-Heteroübergang gebildet, das heißt eine Abfolge von Schichten vom entgegen gesetzten Leitungstyp.

Zur Formung der Dünnschichtsolarzellen 2 ist der Schichtenaufbau 6 in eine Mehrzahl photovoltaisch aktiver Bereiche unterteilt. Die Unterteilung erfolgt durch Einschnitte 13, welche durch eine geeignete Strukturierungstechnologie wie Laserschreiben und mechanisches Abtragen in den Schichtenaufbau 6 eingebracht wurden. Hierbei sind benachbarte Dünnschichtsolarzellen 2 jeweils über einen ersten Elektrodenbereich 14 der Rückelektrodenschicht 9 seriell miteinander verschaltet, wobei durch die beiden randständigen zweiten Elektrodenbereiche 14' der Rückelektrodenschicht 9 Sammelelektroden 5 gegensätzlicher Polarität der miteinander verschalteten Dünnschichtsolarzellen gebildet werden. An den Sammelelektroden 5 kann die von den seriell verschalteten Dünnschichtsolarzellen 2 erzeugte Gesamtspannung, welche sich als Summe der von den einzelnen Dünnschichtsolarzellen 2 erzeugten Zellspannungen ergibt, abgegriffen werden.

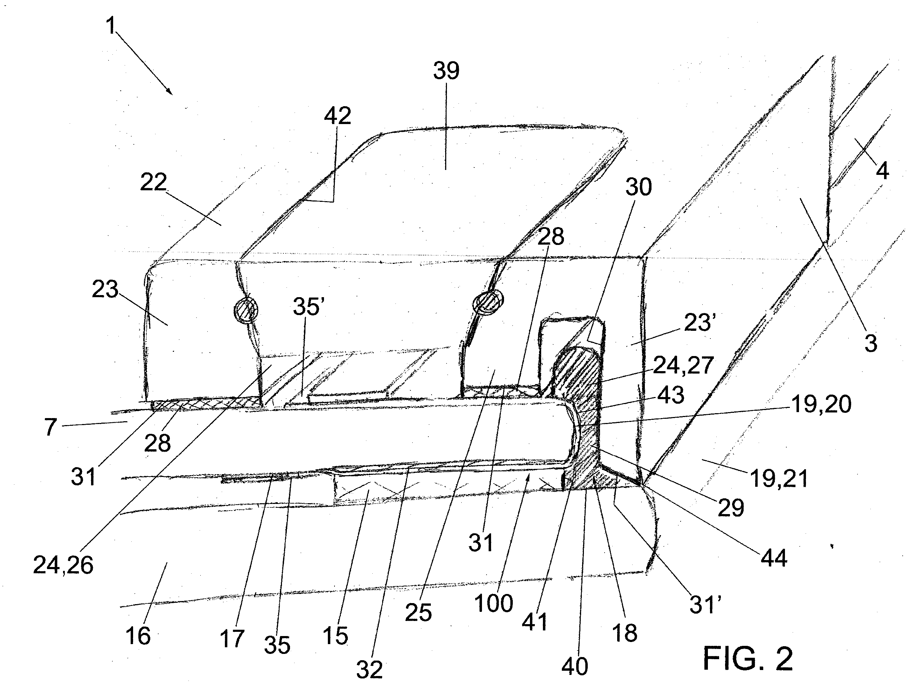

Die beiden Sammelelektroden 5 sind jeweils mit einem bandförmigen Sammelleiter 17 elektrisch verbunden, welcher in Fig. 2 dargestellt ist. Die Sammelleiter 17 sind beispielsweise im Siebdruckverfahren auf den zugehörigen zweiten Elektrodenbereich 14' aufgedruckt. Die Sammelleiter 17 ermöglichen in vorteilhafter Weise eine Kontaktierung an geeigneter Stelle, beispielsweise in der Nähe eines Modulrands 19.

Auf die Frontelektrodenschicht 12 ist eine thermoplastische Zwischenschicht 15 aufgebracht, welche beispielsweise aus Polyvinylbutyral (PVB) oder Ethylenvinylacetat (EVA) besteht. Durch die Zwischenschicht 15 ist das Trägersubstrat 7 mit der Rückseite (Seite II) des Decksubstrats 16 zu einem bewitterungsstabilen Verbund verklebt. Die Zwischenschicht 15 wird durch Erwärmen plastisch verformbar und verbindet beim Abkühlen die beiden Substrate 7, 16 fest miteinander.

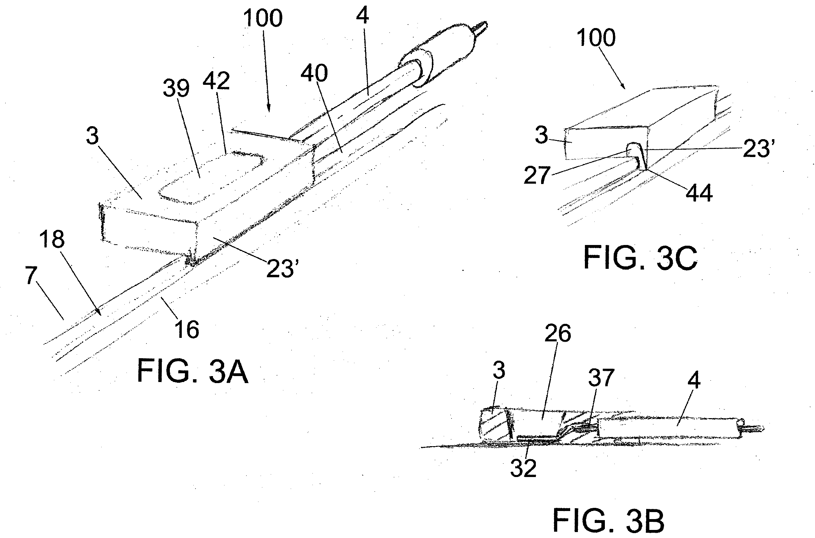

Für eine Erläuterung der erfindungsgemäßen Anschlussanordnung 100, die ein Anschlussgehäuse 3 für einen elektrischen Außenanschluss einer resultierenden Sammelelektrode 5 enthält, seien nun ergänzend die weiteren Figuren betrachtet. Fig. 2 zeigt eine perspektivische Ansicht der Anschlussanordnung 100 mit einer Schnittansicht des Anschlussgehäuses 3, wobei die Schnittlinie entlang einer kürzeren Querrichtung des quader- bzw. rechteckförmigen Dünnschichtsolarmoduls 1 geführt ist. In Fig. 3A ist das Anschlussgehäuse 3 mit Anschlusskabel 4 in einer perspektivischen Ansicht gezeigt. Fig. 3B zeigt das Anschlussgehäuse 3 in einer Schnittansicht, wobei die Schnittlinie in Längsrichtung bzw. senkrecht zur Querrichtung des Dünnschichtsolarmoduls 1 geführt ist.

Wie in Fig. 2 erkennbar, ist an dem in Längsrichtung des Dünnschichtsolarmoduls 1 sich erstreckenden Modulrand 19 ein Trägersubstratrand 20 des Trägersubstrats 7 relativ zu einem gegenüberliegenden Decksubstratrand 21 des Decksubstrats 16 nach innen (in Querrichtung) rückversetzt, so dass sich eine (räumliche) Modulrandzone 18 mit einem überstehenden Substratrandbereich 40 ergibt. Im vorliegenden Beispiel beträgt die entlang der kürzeren Querrichtung des Dünnschichtsolarmoduls 1 sich bemessende Breite des überstehenden Substratrandbereichs 40 ca. 2 bis 3 mm. Als Modulrandzone 18 wird hier und im Weiteren die Raumzone verstanden, die durch den Modulrand 19 und einer fluchtenden Verlängerung des überstehenden Decksubstratrands 21 und einer fluchtenden Verlängerung der Außenfläche (Seite IV) des Trägersubstrats 7 begrenzt wird. Der Modulrand 19 ergibt sich durch den Trägersubstratrand 20 und den Decksubstratrand 21, sowie durch eine seitliche Randfläche 41 des Schichtenaufbaus 6 und der Zwischenschicht 15.

Für einen elektrischen Außenanschluss verfügt das Dünnschichtsolarmodul 1 über zwei gleich aufgebaute Anschlussanordnungen 100, die jeweils ein rückseitig angeordnetes Anschlussgehäuse 3 umfassen. Jede Anschlussanordnung 100 ist einer Sammelelektrode 5 zugeordnet. In Fig. 2 ist zum Zwecke einer einfacheren Darstellung lediglich eine Anschlussanordnung 100 dargestellt. Durch die beiden Anschlussgehäuse 3 kann das Dünnschichtsolarmodul 1 mit weiteren Dünnschichtsolarmodulen zu einem Modulstrang verschaltet oder mit einer elektrischen Last, beispielsweise ein Wechselrichter, verbunden werden. Jedes Anschlussgehäuse 3 verfügt zu diesem Zweck über ein Anschlusskabel 4, wobei gleichermaßen ein Steckerbauteil vorgesehen sein kann. Das Anschlussgehäuse 3 ist beispielsweise als quaderförmiges Spritzgussteil aus Kunststoff gefertigt und hat beispielsweise eine Länge von 50 mm, eine Breite von 20 mm und eine Höhe von 10 mm.

Das Anschlussgehäuse 3 kann zumindest gedanklich in verschiedene Gehäuseabschnitte unterteilt werden. Es umfasst einen Basisabschnitt 22 und Seitenwandabschnitte 23, 23' die gemeinsam mit dem Dünnschichtsolarmodul 1 einen Hohlraum 24 umgrenzen. Der Hohlraum 24 wird durch eine Stützstrebe 25 in eine Kontaktkammer 26 und eine Dichtmassenkammer 27 unterteilt, deren Funktion weiter unten erläutert wird. Das Anschlussgehäuse 3 sitzt auf einer von drei ersten Seitenwandabschnitten 23 und der Stützstrebe 25 gebildeten Bodenfläche 31 der Außenfläche (Seite IV) des Trägersubstrats 7 auf und ist durch eine Klebeschicht 28 mit dem Trägersubstrat 7 fest verbunden. Die Klebeschicht 28 besteht beispielsweise aus einem Acrylat- oder Polyurethankleber. Neben einer einfachen und dauerhaften Verbindung erfüllen diese Kleber eine Dichtfunktion gegenüber Wasser und Luft und schützen die im Anschlussgehäuse 3 enthaltenen elektrischen Komponenten vor Korrosion.

Ein parallel zum Modulrand 19 sich erstreckender zweiter Seitenwandabschnitt 23' des Anschlussgehäuses 3 verfügt über einen abgeschrägte Bodenfläche 31', die mit einer Kontaktkante 44 der Innenfläche (Seite II) des Decksubstrats 16 im überstehenden Substratrandbereich 40 aufsitzt. Eine Abdichtung des Anschlussgehäuses 3 nach außen erfolgt durch eine in der Dichtmassenkammer 27 verteilt angeordnete Dichtmasse 29. Durch die abgeschrägte Bodenfläche 31' ist der zweite Seitenwandabschnitt 23' zum überstehenden Substratrandbereich 40 hin spitz zulaufend ausgebildet. Dies ermöglicht das Aufbringen der Dichtmasse 29 auf den überstehenden Substratrandbereich 40 noch vor dem Befestigen Anschlussgehäuses 3 am Verbund. Zudem befindet sich Dichtmasse 29 auch zwischen der Bodenfläche 31' und dem überstehenden Substratrandbereich 40, so dass bei einer klebenden Dichtmasse eine Befestigung des Anschlussgehäuses 3 am Verbund und eine hervorragende Abdichtung der Dichtkammer 27 nach außen erreicht wird. Durch die Dichtmasse 29 kann ein Eindringen von Wasser und Luft in das Anschlussgehäuse 3 im Bereich des zweiten Seitenwandabschnitts 23' zuverlässig und sicher verhindert werden. Beispielsweise kann zu diesem Zweck eine Dichtmasse 29 aus Polyisobutylen eingesetzt werden.

In Fig. 3C ist eine Variante des Anschlussgehäuses 3 gezeigt, bei der sich der die Dichtmassenkammer 27 begrenzende zweite Seitenwandabschnitt 23' des Anschlussgehäuses 3 bis zur Kontaktkante 44 verjüngt, d.h. spitz zuläuft.

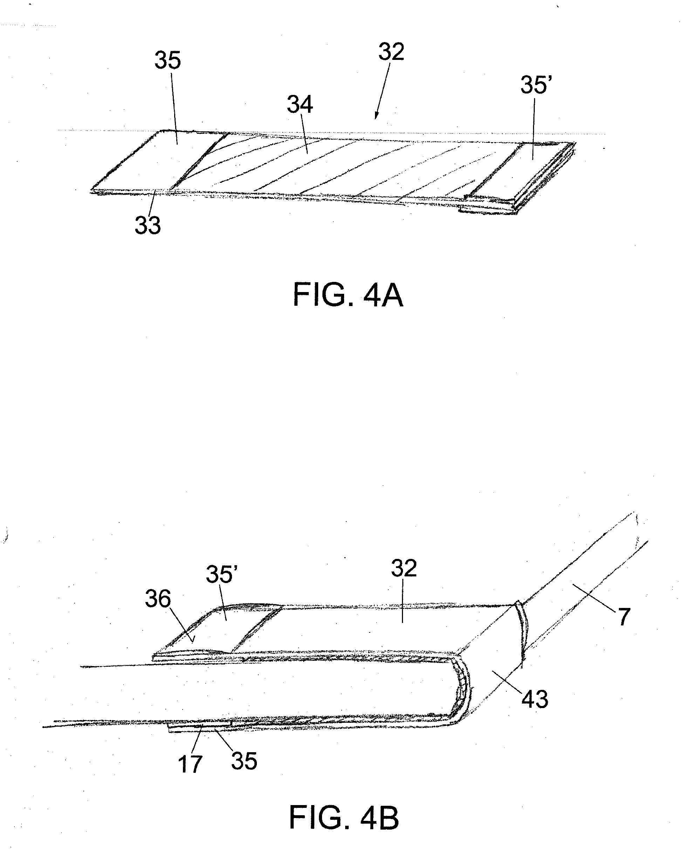

Der mit der zugehörigen Sammelelektrode 5 elektrisch verbundene Sammelleiter 17 und das Anschlusskabel 4 sind durch ein Anschlussband 32 elektrisch miteinander verbunden. Das Anschlussband 32 ist in Fig. 4A im unverbauten Zustand gezeigt. Es umfasst einen Folienleiter 33 aus einem metallischen Material, beispielsweise Aluminium oder Kupfer, auf dem einseitig ein beidseitig klebendes Klebeband 34 mit einem Kleber auf Acryl-, Polyurethan- oder Polyisobutylenbasis aufgebracht ist. Das Anschlussband 32 verfügt über zwei klebbandfreie Endabschnitte 35, 35', wobei ein Endabschnitt 35' mit einer Zinnschicht 36 versehen ist. Im vorliegenden Ausführungsbeispiel hat das Anschlussband 32 eine Länge im Bereich von 30 bis 50 mm und eine Breite von ca. 10 mm.

Wie in Fig. 4B erkennbar, ist das Anschlussband 32 im verbauten Zustand um den nach innen rückversetzten Trägersubstrand 20 herum gelegt, wobei der nichtverzinnte Endabschnitt 35 auf der Innenseite des Trägersubstrats 7 mit dem Sammelleiter 17 elektrisch verbunden ist und der verzinnte Endabschnitt 35' auf der Außenfläche (Seite IV) des Trägersubstrats 7 zu liegen kommt. Durch das Klebeband 34 wird das Anschlussband 32 am Trägersubstrat 7 befestigt und in seiner Lage fixiert. Eine dauerhafte elektrische Verbindung zwischen dem nichtverzinnten Endabschnitt 35 und dem Sammelleiter 17 erfolgt beispielsweise durch Ultraschallverlötung.

Wie in Fig. 1 gezeigt, ist das Anschlussband 32 am Modulrand 19 in der Modulrandzone 18 zwischen den beiden Substraten 7, 16 herausgeführt. Durch den überstehenden Substratrandbereich 40 ist das Anschlussband 32 vor mechanischen Einwirkungen geschützt. Zudem ist ein um den Trägersubstratrand 20 herum geführter Anschlussbandabschnitt 43 durch die (anliegende) Dichtmasse 29 zur äußeren Umgebung hin wasser- und luftdicht versiegelt. Die Dichtmasse 29 wird zu diesem Zweck noch vor dem Aufsetzen des Anschlussgehäuses 3 gezielt auf den Anschlussbandabschnitt 43 aufgebracht. Durch die abgeschrägte Bodenfläche 31' bzw. zum überstehenden Substratrandbereich 40 hin spitz zulaufenden zweiten Seitenwandabschnitt 23' kann ein Abscheren der Dichtmasse 29 vom Anschlussbandabschnitt 43 vermieden werden. Zudem wird die Dichtmasse 29 zum Anschlussbandabschnitt 43 gedrückt, wodurch die Versiegelung verbessert wird. Dies gilt insbesondere für die in Fig. 3C gezeigte Variante.

Auf der Außenseite des Trägersubstrats 7 ist das Anschlussgehäuse 3 so platziert, dass sich der verzinnte Endabschnitt 35' innerhalb der Kontaktkammer 26 befindet. Wie in der Schnittansicht von Fig. 3B erkennbar, ist ein frei liegender Endbereich 38 eines inneren Kabelleiters 37 des Anschlusskabels 4 an den verzinnten Endabschnitt 35' elektrisch angeschlossen, beispielsweise durch eine Lötverbindung, was in Fig. 3B nicht näher dargestellt ist. Das Anschlussgehäuse 3 weist zu diesem Zweck ein in eine Gehäuseöffnung 42 eingesetztes, herausnehmbares Einsatzteil 39 auf, wobei durch die Gehäuseöffnung 42 ein freier Zugang zur Kontaktkammer 26 zum Verbinden von Endbereich 38 und Endabschnitt 35' nach Fixieren des Anschlussgehäuses 3 am Dünnschichtsolarmodul 1 geschaffen wird.

Die beiden Anschlussanordnungen 100 für die Spannungsanschlüsse 5 können in einfacher und kostengünstiger Weise vollautomatisiert hergestellt werden. Zu diesem Zweck werden nach Strukturieren der Dünnschichtsolarzellen 2 die Anschlussbänder 32 auf der Innenseite (Seite III) des Trägersubstrats 7 befestigt und um den Trägersubstratrand 20 herum bis zur Außenseite des Trägersubstrats 7 geführt. Zudem werden die Endabschnitte 35 der Anschlussbänder 32 mit dem jeweils zugehörigen Sammelleiter 17 beispielsweise durch Ultraschallverschweißen fest verbunden. Anschließend erfolgt eine Verklebung der beiden Substrate 7, 16 durch die Zwischenschicht 15. Nach Aufbringen der Dichtmasse 29 auf den überstehenden Substratrandbereich 40, insbesondere auf die beiden Anschlussbandabschnitte 43, werden die beiden Anschlussgehäuse 3 auf die Außenseite des Trägersubstrats 7 aufgesetzt und jeweils durch die Klebeschicht 28 befestigt. Schließlich erfolgt die elektrische Verbindung des jeweiligen Anschlussbands 32 mit dem frei liegenden Endbereich 38 des zugehörigen Anschlusskabels 4, zu welchem Zweck das Einsatzteil 39 aus seiner Gehäuseöffnung 42 entfernt und anschließend wieder eingesetzt wird. Die beiden Anschlussanordnungen 100 können an nur einem Modulrand 19 oder beispielsweise auch verteilt an zwei gegenüberliegenden Modulrändern 19, die jeweils über eine Modulrandzone 18 verfügen, angeordnet sein. Gleichermaßen wäre es auch möglich, dass nur ein einziges Anschlussgehäuse 3 für einen elektrischen Außenanschluss der beiden Sammelelektroden 5 vorgesehen ist. In diesem Fall wäre dafür Sorge zu tragen, dass ein elektrischer Überschlag zwischen den beiden Anschlussbändern 32 vermieden wird, was beispielsweise durch eine isolierende Trennwand erreicht werden kann.

### Bezugszeichenliste

- 1: Dünnschichtsolarmodul
- 2: Dünnschichtsolarzelle
- 3: Anschlussgehäuse
- 4: Anschlusskabel
- 5: Sammelelektrode
- 6: Schichtenaufbau
- 7: Trägersubstrat
- 8: Absorberschicht
- 9: Rückelektrodenschicht
- 10: Halbleiterschicht
- 11: Pufferschicht
- 12: Frontelektrodenschicht
- 13: Einschnitt
- 14, 14': Elektrodenbereich
- 15: Zwischenschicht
- 16: Decksubstrat
- 17: Sammelleiter
- 18: Modulrandzone
- 19: Modulrand
- 20: Trägersubstratrand
- 21: Decksubstratrand
- 22: Basisabschnitt
- 23, 23': Seitenwandabschnitt
- 24: Hohlraum
- 25: Stützstrebe
- 26: Kontaktkammer
- 27: Dichtmassenkammer
- 28: Klebeschicht
- 29: Dichtmasse
- 30: Innenwand
- 31, 31': Bodenfläche
- 32: Anschlussband
- 33: Folienleiter
- 34: Klebeband
- 35, 35': Endabschnitt
- 36: Zinnschicht
- 37: Kabelleiter
- 38: Endbereich
- 39: Einsatzteil
- 40: Substratrandbereich
- 41: Randfläche
- 42: Gehäuseöffnung
- 43: Anschlussbandabschnitt
- 44: Bodenkante
- 100: Anschlussanordnung

## Patentansprüche

1. Solarmodul (1), insbesondere Dünnschichtsolarmodul, welches umfasst:
einen laminierten Verbund aus zwei Substraten (7, 16), wobei wenigstens ein Substratrand (20) des einen Substrats (7) relativ zu einem gegenüberliegenden Substratrand (21) des anderen Substrats (16) nach innen rückversetzt ist, so dass eine Modulrandzone (18) mit einem überstehenden Substratrandbereich (40) gebildet wird,
eine zwischen den beiden Substraten (7, 16) befindliche Serienschaltung aus einer Mehrzahl Solarzellen (2), die über zwei Sammelelektroden (5) zum Abgreifen einer durch die Solarzellen (2) erzeugten Gesamtspannung verfügt,
zwei Anschlussanordnungen (100), welche jeweils einer Sammelelektrode (5) zugeordnet sind, wobei jede Anschlussanordnung (100) aufweist:
- ein mit der zugeordneten Sammelelektrode (5) elektrisch leitend verbundenes Anschlussband (32), das in der Modulrandzone (18) zwischen den beiden Substraten (7, 16) um den nach innen rückversetzten Substratrand (20) herum auf eine Substrataußenfläche geführt ist,
- ein am Verbund befestigtes Anschlussgehäuse (3) mit einem mit dem Anschlussband (32) elektrisch leitend verbundenen Anschlussbauteil (4), wobei das Anschlussgehäuse (3) eine Dichtmassenkammer (27) aufweist, die eine Dichtmasse (29) enthält, welche das Anschlussband (32) in einem um den Substratrand (20) herumgeführten Anschlussbandabschnitt (43) abdichtet, wobei ein die Dichtmassenkammer (27) begrenzender Wandabschnitt (23') des Anschlussgehäuses (3) zum überstehenden Substratrandbereich (40) hin spitz zulaufend ausgebildet ist.

2. Solarmodul (1) nach Anspruch 1, bei welchem der die Dichtmassenkammer (27) begrenzende Wandabschnitt (23') des Anschlussgehäuses (3) eine dem überstehenden Substratrandbereich (40) abschnittsweise anliegende, abgeschrägte Bodenfläche (31') aufweist.

3. Solarmodul (1) nach Anspruch 2, bei welchem das Anschlussgehäuse (3) durch Dichtmasse (29) zwischen der abgeschrägten Bodenfläche (31') und dem überstehenden Substratrandbereich (40) befestigt ist.

4. Solarmodul (1) nach einem der Ansprüche 1 bis 3, bei welchem das Anschlussband (32) einer jeweiligen Anschlussanordnung (100) mit einem Klebemittel (34), beispielsweise ein doppelseitiges Klebeband, zum Befestigen an einem Substrat (7) versehen ist.

5. Solarmodul (1) nach einem der Ansprüche 1 bis 8, bei welchem das Anschlussband (32) einer jeweiligen Anschlussanordnung (100) durch einen streifenförmigen Sammelleiter (17) mit der zugehörigen Sammelelektrode (5) elektrisch leitend verbunden ist.

6. Solarmodul (1) nach Anspruch 5, bei welchem das Anschlussband (32) mit dem Sammelleiter (17), beispielsweise durch Ultraschallverbinden, fest verbunden ist.

7. Solarmodul (1) nach einem der Ansprüche 1 bis 6, bei welchem das Anschlussband (32) einer jeweiligen Anschlussanordnung (100) über einen verzinnten Endabschnitt (35') zur Verbindung mit dem Anschlussbauteil (4) verfügt.

8. Solarmodul (1) nach einem der Ansprüche 1 bis 7, bei welchem das Anschlussgehäuse (3) einer jeweiligen Anschlussanordnung (100) ein in eine Gehäuseöffnung (42) eingesetztes, herausnehmbares Einsatzteil (39) aufweist, wobei durch die Gehäuseöffnung (39) Zugang zu einer Kontaktkammer (26) zum elektrischen Verbinden von Anschlussband (32) und Anschlussbauteil (4) geschaffen wird.

9. Solarmodul (1) nach einem der Ansprüche 1 bis 8, bei welchem die beiden Anschlussanordnungen (100) über ein gemeinsames Anschlussgehäuse (3) verfügen.

10. Verfahren zur Herstellung eines Solarmoduls, insbesondere Dünnschichtsolarmoduls (1), mit den folgenden Schritten:
- Ausbilden einer Serienschaltung aus einer Mehrzahl Solarzellen (2) auf einem ersten Substrat (7), wobei die Serienschaltung über zwei Sammelelektroden (5) zum Abgreifen der durch die Solarzellen (2) erzeugten Gesamtspannung verfügt;
- Elektrisches Verbinden der Sammelelektroden (5) mit Anschlussbändern (32);
- Herstellen eines Verbunds aus dem ersten Substrat (7) mit einem zweiten Substrat (16), wobei wenigstens ein Substratrand (20) des einen Substrats (7) relativ zu einem gegenüberliegenden Substratrand (21) des anderen Substrats (16) nach innen rückversetzt ist, so dass eine Modulrandzone (18) mit einem überstehenden Substratrandbereich (40) gebildet wird, wobei die Anschlussbänder (32) in der Modulrandzone (18) zwischen den beiden Substraten (7, 16) um den nach innen rückversetzten Substratrand (20) herum auf eine Substrataußenfläche geführt werden;
- Aufbringen einer Dichtmasse (29) auf das andere Substrat (16) wenigstens in einem um den Substratrand (20) herumgeführten Anschlussbandabschnitt (43);
- Aufsetzen eines Anschlussgehäuses (3) mit einem oder mehreren Anschlussbauteilen (4) für einen elektrischen Außenanschluss auf den Verbund, wobei das Anschlussgehäuse eine Dichtmassenkammer (27) zum Aufnehmen der Dichtmasse (29) mit einem spitz zulaufend ausgebildeten Wandabschnitt (23') aufweist, der auf den überstehenden Substratrandbereich (40) aufgesetzt wird;
- Elektrisches Verbinden der mit den Sammelelektroden (5) verbundenen Anschlussbänder (32) mit den Anschlussbauteilen (4).

## Claims

1. Solar module (1), in particular thin film solar module, comprising:
a laminated compound of two substrates (7, 16), wherein at least one substrate edge (20) of the one substrate (7) is set back towards the interior relatively to an opposing substrate edge (21) of the other substrate (16) so that a module edge zone (18) with a protruding substrate edge region (40) is formed,
a series connection of a plurality of solar cells (2) arranged between the two substrates (7, 16) which has two bus bars (5) for picking off a total voltage generated by the solar cells (2),
two connection arrangements (100) which are respectively associated with a bus bar (5), wherein each connection arrangement (100) comprises:
- a connection ribbon (32) electrically connected to the associated bus bar (5) which in the module edge zone (18) between the two substrates (7, 16) is led around the substrate edge (20) set back to the interior misaligned to a substrate outer face,
- a connection housing (3) fixed to the compound and electrically conductively connected to the connection ribbon (32), wherein the connection housing (3) has a sealing mass chamber (27) containing a sealing mass (29), which seals the connection ribbon (32) in a connection ribbon section (43) led around the substrate edge (20), wherein a wall section (23') of the connection housing (3) surrounding the sealing mass chamber (27) is tapering towards the substrate edge region (40).

2. Solar module (1) according to claim 1, wherein the wall section (23') surrounding the sealing mass chamber (27) of the connection housing (3) has a chamfering bottom face (31') resting on the protruding substrate edge section (40).

3. Solar module (1) according to claim 2, wherein the connection housing (3) is fixed by sealing mass (2) between the chamfered bottom face (31') and the protruding substrate edge section (40).

4. Solar module (1) according to one of the claims 1 through 3, wherein the connection ribbon (32) of a respective connection arrangement (100) is provided with an adhesive means (34), for instance a double-sided adhesive tape, for fixing to a substrate (7).

5. Solar module (1) according to one of the claims 1 through 4, wherein the connection ribbon (32) of a respective connection arrangement (100) is electrically conductively connected to the associated bus bar (5) by a strip-like collecting conductor (17).

6. Solar module (1) according to claim 5, wherein the connection ribbon (32) is fixedly connected to the bus bar (17), for instance by ultrasonic fixing.

7. Solar module (1) according to one of the claims 1 through 6, wherein the connection ribbon (32) of a respective connection arrangement (100) has a tinned end section (35') for connecting to the connection component (4).

8. Solar module (1) according to one of the claims 1 through 7, wherein the connection section (3) of a respective connection arrangement (100) has a removable inserting component (39) inserted into a housing opening (42), wherein access to a contact chamber (26) is provided by the housing opening (39) for electrically connecting the connection ribbon (32) and connection component (4).

9. Solar module (1) according to one of the claims 1 through 8, wherein the two connection arrangements (100) have a common connection housing (3).

10. Method for the production of a solar module, in particular thin-film solar module (1) comprising the following steps:
- forming of a series connection of a plurality of solar cells (2) on a first substrate (7) wherein the series connection has two bus bars (5) for picking off a total voltage generated by the solar cells (2),
- electrically connecting of the bus bars (5) with connection ribbons (32);
- producing of a compound by the first substrate (7) and a second substrate (16) wherein at least one substrate edge (20) of the one substrate (7) is set back to the interior relatively to an opposing substrate edge (21) of the other substrate (16) so that a module edge zone (18) with a protruding substrate edge region (40) is formed, wherein the connection ribbons (32) are led around the substrate edge (20) set back to the interior in the module edge zone (18) between the two substrates (7, 16);
- applying of a sealing mass (29) on the other substrate (16) at least in a connection ribbon section (43) led around the substrate edge (20);
- applying of a connection housing (3) having one or more connection compounds (4) on the compound, wherein the the connection housing has a sealing mass chamber (27) for receiving the sealing mass (29) having a tapering wall section (23') which is applied on the protruding substrate edge region (40);
- electrically connecting of the connection ribbons (32) connected with the bus bars (5) to the connection components (4).

## Revendications

1. Module solaire (1), en particulier module solaire à couches minces, comprenant:
un composite stratifié composé de deux substrats (7, 16), où au moins un bord de substrat (20) de l'un des substrats (7) est déplacé vers l'intérieur par rapport à un bord de substrat opposé (21) de l'autre substrat (16), de telle manière qu'une zone de bord d'un module (18) est formée avec une zone en saillie de bord du substrat (40),
un circuit en série composé d'une pluralité de cellules solaires (2) situé entre les deux substrats (7, 16), qui dispose de deux électrodes collectives (5) pour saisir une tension totale générée par les cellules solaires (2),
deux configurations de connexion (100), dont chacune est assignée à une électrode collective (5), où chaque arrangement de connexion (100) présente:
- une bande de raccordement (32) reliée électriquement à l'électrode collective assignée (5) qui est guidée dans la zone de bord du module (18) entre les deux substrats (7, 16) autour du bord du substrat décalé vers intérieur (20) sur une surface extérieure du substrat,
- un boîtier de connexion (3) attaché au composite avec un composant de connexion (4) relié électriquement à la bande de raccordement (32), où le boîtier de connexion (3) présente une chambre pour une masse d'étanchéité (27) qui contient une masse d'étanchéité (29) qui scelle la bande de raccordement (32) dans une section de bande de raccordement (43) guidée autour du bord du substrat (20), où une section de paroi (23') du boîtier de connexion (3) limitant la chambre de la masse d'étanchéité (27) est formée de façon pointue vers la zone en saillie de bord du substrat (40).

2. Module solaire (1) selon la revendication 1, où la section de paroi (27') limitant la chambre de la masse d'étanchéité (27)) du boîtier de raccordement (3) présente une surface inférieure (31') chanfreinée et adjacente par sections à la zone en saillie du bord de substrat (40).

3. Module solaire (1) selon la revendication 2, où le boîtier de connexion (3) est fixé par une masse d'étanchéité (29) entre la surface inférieure (31') chanfreinée et la zone en saillie du substrat (40).

4. Module solaire (1) selon l'une des revendications 1 à 3, où le ruban de connexion (32) de l'arrangement de connexion (100) respectif est pourvu d'un adhésif (34), par exemple un ruban adhésif à double face, pour la fixation sur un substrat (7).

5. Module solaire (1) selon l'une des revendications 1 à 8, où la bande de raccordement (32) de l'arrangement de connexion (100) respectif est reliée électriquement à l'électrode collective associée (5) par un conducteur collectif en forme de bande (17).

6. Module solaire (1) selon la revendication 5, où la bande de raccordement (32) est solidement rattachée au conducteur collectif (17), par exemple par une connexion par ultrasons.

7. Module solaire (1) selon l'une des revendications 1 à 6, où la bande de connexion (32) de l'arrangement de connexion (100) respectif dispose d'une section d'extrémité étamée (35') pour la connexion au composant de connexion (4).

8. Module solaire (1) selon l'une des revendications 1 à 7, où le boitier de connexion (3) de l'arrangement de connexion (100) respectif présente une pièce d'insertion (39) amovible insérée dans une ouverture du boitier (42) (39), où l'accès à une chambre de contact (26) pour la connexion électrique de la bande de raccordement (32) et le composant de connexion (4) est obtenu par l'ouverture du boitier.

9. Module solaire (1) selon l'une des revendications 1 à 8, où les deux arrangements de connexion (100) disposent d'un boitier de connexion commun (3).

10. Procédé pour la production d'un module solaire, en particulier un module solaire à couches minces (1), avec les étapes suivantes:
- formation d un circuit en série à partir d'une pluralité de cellules solaires (2) sur un premier substrat (7), où le circuit en série dispose de deux électrodes collectives (5) pour saisir la tension totale générée par les cellules solaires (2) ;
- connexion électrique des électrodes de collecte (5) avec des bandes de raccordement (32) ;
- fabrication d'un composite à partir du premier substrat (7) avec un deuxième substrat (16), où au moins un bord de substrat (20) de l'un des substrats (7) par rapport à un bord de substrat (21) opposé de l'autre substrat (16) est déplacé vers l'intérieur, de sorte qu'une zone de bord du module (18) est formée avec une zone de substrat en saillie (40), où les bandes de raccordement (32) dans la zone de bord du module (18) entre les deux substrats (7, 16) autour du bord de substrat décalé vers l'intérieur (20) est guidé sur une surface extérieure du substrat (20); de sorte qu'un substrat (20) est déplacé vers l'intérieur ;
- l'application d'une masse d'étanchéité (29) sur l'autre substrat (l6) au moins sur une section de bande de raccordement (43) autour du substrat (20);
- pose d'un boîtier de connexion (3) avec un ou plusieurs composants de connexion (4) pour une connexion électrique externe au composite, où le boitier de connexion présente une chambre pour une masse d'étanchéité (27) pour recevoir la masse d'étanchéité (29) avec une section de paroi (23') de forme pointue qui est montée sur la zone du substrat (40) en saillie;
- connexion électrique des bandes de raccordement (32) reliée aux électrodes collectives (5) avec les composants de connexion (4).
